(19) Europäisches Patentamt
European Patent Office
Office européen des brevets

(11) **EP 3 909 767 A1**

(12) **EUROPEAN PATENT APPLICATION**
published in accordance with Art. 153(4) EPC

(43) Date of publication:
**17.11.2021 Bulletin 2021/46**

(51) Int Cl.:
**B32B 27/36** *(2006.01)*  **B32B 9/00** *(2006.01)*

(21) Application number: **20737961.1**

(22) Date of filing: **07.01.2020**

(86) International application number:
**PCT/JP2020/000131**

(87) International publication number:
**WO 2020/145254 (16.07.2020 Gazette 2020/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.01.2019 JP 2019002744**

(71) Applicant: **TOYOBO CO., LTD.**
**Osaka-shi**
**Osaka 530-8230 (JP)**

(72) Inventors:
• YAMAZAKI, Atsushi
Inuyama-shi, Aichi 484-8508 (JP)
• GOTO, Takamichi
Inuyama-shi, Aichi 484-8508 (JP)
• NUMATA, Yukihiro
Inuyama-shi, Aichi 484-8508 (JP)

(74) Representative: **Vossius & Partner**
**Patentanwälte Rechtsanwälte mbB**
**Siebertstraße 3**
**81675 München (DE)**

(54) **LAMINATED FILM**

(57) To provide a laminated body which exhibits excellent production stability during production and excellent economical efficiency, has excellent barrier performance even in a high-temperature and high-humidity environment and can maintain excellent barrier properties and toughness even when used in applications where severe moist heat treatment such as boiling treatment is performed.

The laminated film according to the present invention has laminated therein at least a base material layer, a covering layer, and an inorganic thin-film layer in this order, and satisfies requirements (a)-(d):

(a) the base material layer comprises a resin composition that contains at least 70 mass% of polybutylene terephthalate resin;

(b) the laminated film has a piercing strength of 0.6 N/$\mu$m or more as measured in accordance with JIS Z 1707 after having undergone a 95°C-boiling treatment for 30 minutes;

(c) the base material layer has a surface orientation degree of 0.144-0.160; and

(d) when the value of oxygen transmission rate obtained by measuring the laminated film under a 23°C×65%RH condition is defined as (A) and the value of oxygen transmission rate obtained by measuring same under a 40°C×90%RH condition is defined as (B), the barrier value deterioration rate, determined by the following formula, of the laminated film is 300% or less under high-temperature and high-humidity condition.

```
Barrier value deterioration rate (%) under high-

temperature and high-humidity condition = (B/A) ×100
```

**Description**

TECHNICAL FIELD

The present invention relates to a laminated body used in the packaging field of food products, pharmaceutical products, industrial products, and the like. More specifically, the present invention relates to a gas barrier laminated body which exhibits excellent gas barrier properties, dimensional stability, processability, bag breakage resistance and exhibits excellent gas barrier properties even in applications that require storage and transportation in a high-temperature and high-humidity environment and in applications that undergo harsh moist heat treatment such as boiling sterilization.

BACKGROUND ART

Packaging materials used for food products, pharmaceutical products and the like are required to be equipped with a property of blocking gases such as oxygen and water vapor, namely, gas barrier properties in order to suppress the oxidation of proteins and fats, to maintain the taste and freshness, and to maintain the efficacy of pharmaceutical products. Gas barrier materials used for electronic devices such as solar cells and organic EL, electronic parts, and the like are required to exhibit higher gas barrier properties than packaging materials for food products.

Hitherto, in food applications that require blocking of various gases such as water vapor and oxygen, gas barrier laminated bodies in which metal thin films formed of aluminum and the like and inorganic thin films formed of inorganic oxides such as silicon oxide and aluminum oxide are formed on the surface of base material films formed of plastics are generally used. Among these, those in which thin films (inorganic thin film layers) of inorganic oxides such as silicon oxide, aluminum oxide, and a mixture thereof are formed on the surface of base material films are widely used since these gas barrier laminated bodies are transparent and the contents are visible.

Barrier films formed of transparent inorganic thin films have become to be used in various situations because of their convenience and performance, and the required quality for these has also increased. It is required to be able to maintain high barrier properties even in harsher environments, for example, long-term transportation (for example, export to overseas) in a hot and humid environment and warehouse storage in a hot and humid climate like Japan. There is a demand for barrier films which can withstand harsh sterilization treatments such as boiling and retorting that are applied in order to extend the expiration date of contents in food packaging.

Among the sterilization applications, particularly in the case of pouches for boiling, a great external load is applied to the bag since the pressure of the contents increases during the boiling sterilization treatment. Hence, in addition to sufficient water resistance, heat resistance, and gas barrier properties, high toughness (bag breakage resistance and piercing resistance) is required at the same time. With regard to these required performances, a general laminated film in which a gas barrier layer is laminated on a polyester film exhibits excellent barrier performance, heat resistance, and processability but has a problem of exhibiting insufficient toughness. Meanwhile, a conventional technology in which a gas barrier layer is laminated on a polyamide film has also been proposed (for example, Patent Document 1). A film exhibiting both toughness and barrier properties of the polyamide film is thus obtained. However, gas barrier laminated films in which a polyamide film is used as a base material have a problem that it is difficult to use the films in the harsh environment as described above since the barrier properties may be significantly deteriorated by the weak adhesive properties in a moist heat environment due to the characteristics of the polyamide film and the expansion and contraction of the polyamide film base material due to moisture absorption. A polyamide film is inferior to a polyester film in terms of heat resistance and also has a processing problem so that heat shrinkage wrinkling easily occurs during coating and drying of a coat.

In order to cope with this problem, a technology has been proposed in which a packaging material for boiling treatment or retorting treatment, which is inexpensive and exhibits excellent low elution properties and transparency, is obtained by using a layer having a biaxially stretched multi-layer film obtained by biaxially stretching a multi-layer film including a polyester-based resin layer and a polyamide-based resin layer as the base material layer of a transparent gas barrier film (for example, Patent Document 2). However, this conventional technology easily undergoes peeling off at the interface between the polyester-based resin layer and the polyamide-based resin layer and there is thus a problem that the bag is easily broken when dropped and the contents easily leak.

A technology has been known in which a biaxially stretched polybutylene terephthalate-based film, which can be used even under harsh retorting conditions of 130°C or more and exhibits excellent compression resistance, impact resistance, and heat resistance, is obtained by forming a deposited film formed of an inorganic oxide on a biaxially stretched polybutylene terephthalate-based film formed of at least either of a polybutylene terephthalate resin or a polyester-based resin composition in which polyethylene terephthalate (PET) resin is blended in polybutylene terephthalate (PBT) resin in a range of 30 wt% or less (for example, Patent Document 3). However, a film production method by tubular simultaneous biaxial stretching disclosed in the conventional technology has a problem that the thickness accuracy is poor because of the production method and not only the film is inferior in impact resistance since the plane orientation coefficient does not increase but also the film is easily stretched and is inferior in processability when subjected to processing such as a step of applying an adhesive to the film. PBT has a lower glass transition temperature than PET, and the film thus has a characteristic that the film is easily stretched when tension is applied at high temperatures. For this reason, when tension is applied while heating is performed in each processing step, the film base material is stretched and cracking occurs in the previously formed inorganic thin film layer. As a result, there is a problem that the barrier properties of the obtained barrier film decrease.

In Patent Documents 1, 2, and 3, the retorting resistant barrier performance has been investigated but it has not been investigated to achieve the barrier performance, boiling performance, and toughness at the same time in a high-temperature and high-humidity environment.

As described above, it is the current situation that a laminated film has not been obtained which exhibits excellent production stability during production, processing stability and economical efficiency, can maintain excellent barrier performance even in harsh environments such as high-temperature and high-humidity environments, and can maintain barrier properties, adhesive properties, and toughness even after sterilization treatment such as boiling treatment is performed.

PRIOR ART DOCUMENT

PATENT DOCUMENTS

Patent Document 1: JP-B-4857482
Patent Document 2: JP-A-2013-154605
Patent Document 3: JP-A-2012-214248

SUMMARY OF THE INVENTION

PROBLEMS TO BE SOLVED BY THE INVENTION

The present invention has been made against the background of the problems of the prior art and an object thereof is to provide a laminated body which has excellent barrier performance even in a high-temperature and high-humidity environment and can maintain excellent barrier properties and toughness even when used in applications where severe moist heat treatment such as boiling treatment is performed.

MEANS FOR SOLVING THE PROBLEMS

The laminated film of the present invention, which solves the above problems, has the following aspects.
(1) The laminated film according to the present invention has laminated therein at least a base material layer, a covering layer, and an inorganic thin-film layer in this order, and satisfies requirements (a)-(d):

(a) the base material layer comprises a resin composition that contains 70 mass% or more of polybutylene terephthalate resin;
(b) the laminated film has a piercing strength of 0.6 N/$\mu$m or more as measured in accordance with JIS Z 1707 after having undergone a 95°C-boiling treatment for 30 minutes;
(c) the base material layer has a surface orientation degree of 0.144-0.160; and
(d) when the value of oxygen transmission rate obtained by measuring the laminated film under a 23°C×65%RH condition is defined as (A) and the value of oxygen transmission rate obtained by measuring same under a 40°C×90%RH condition is defined as (B), the barrier value deterioration rate, determined by the following formula, of the laminated film is 300% or less under high-temperature and high-humidity condition.

$$\text{Barrier value deterioration rate (\%) under high-temperature and high-humidity condition} = (B/A) \times 100$$

(2) The laminated film according to (1), in which the base material layer further satisfies the following requirement (e):

(e) heat shrinkages of the base material layer at 150°C in a longitudinal direction and a transverse direction are both 4.0% or less.

(3) The laminated film according to (1) or (2), in which the inorganic thin film layer is a layer formed of a composite oxide of silicon oxide and aluminum oxide.

(4) The laminated film according to any one of (1) to (3), in which the covering layer comprises a resin composition containing a resin having an oxazoline group.

EFFECT OF THE INVENTION

The laminated film of the present invention has excellent barrier performance even in a high-temperature and high-humidity environment. Hence, degradation of the contents can be suppressed even in harsh transportation and storage environments. The laminated film exhibits excellent barrier properties and adhesive properties before and after a boiling treatment, and there is thus no problem that the contents are degraded or the contents leak. The laminated film exhibits excellent toughness as a base material, and there is thus little risk that the bag is punctured or torn. The laminated film of the present invention exhibits excellent processability and can be easily produced, and it is thus possible to provide a gas barrier film exhibiting both excellent economical efficiency and excellent production stability.

MODE FOR CARRYING OUT THE INVENTION

The laminated film of the present invention is a laminated film which includes at least three layers of a base material layer/a covering layer/an inorganic thin film layer laminated in this order and satisfies the following requirements (a)-(d):

(a) the base material layer comprises a resin composition that contains 70 mass% or more of polybutylene terephthalate resin;
(b) the laminated film has a piercing strength of 0.6 N/$\mu$m or more as measured in accordance with JIS Z 1707 after having undergone a 95°C-boiling treatment for 30 minutes;
(c) the base material layer has a surface orientation degree of 0.144-0.160; and
(d) when the value of oxygen transmission rate obtained by measuring the laminated film under a 23°C$\times$65%RH condition is defined as (A) and the value of oxygen transmission rate obtained by measuring same under a 40°C$\times$90%RH condition is defined as (B), the barrier value deterioration rate, determined by the following formula, of the laminated film is 300% or less under high-temperature and high-humidity condition.

$$\text{Barrier value deterioration rate (\%) under high-}$$
$$\text{temperature and high-humidity condition = (B/A) \times 100}$$

The present inventors have found out that favorable barrier performance can be maintained even in a high-temperature and high-humidity environment in a case where a biaxially stretched polyester film containing a predetermined amount of polybutylene terephthalate is used as the base material layer and an inorganic thin film layer is laminated on the base material layer to form a base material laminated film. The present inventors have found out that the barrier properties and adhesive properties after a boiling treatment are excellent and also toughness as a base material is excellent as the polybutylene terephthalate-based biaxially stretched polyester film exhibiting excellent moisture resistance is used as a base material instead of a polyamide layer and a covering layer is provided between the inorganic thin film layer and the base material, and have thus completed the present invention.
Hereinafter, the base material layer and the respective layers laminated on this base material layer will be described in order.

[Base Material Layer]

The base material layer used in the present invention is a biaxially stretched film formed of a resin composition containing PBT at 70 mass% or more. The PBT content is more preferably 75 mass% or more. When the PBT content is less than 70 mass%, the piercing strength decreases and the film characteristics are not sufficient.
PBT contains terephthalic acid as a dicarboxylic acid component at preferably 90 mol% or more, more preferably 95 mol% or more, still more preferably 98 mol% or more, most preferably 100 mol%. PBT contains 1,4-butanediol as a glycol component at preferably 90 mol% or more, more preferably 95 mol% or more, still more preferably 97 mol% or more. Most preferably, PBT does not contain any substance other than by-products generated by an ether bond of 1,4-butanediol during polymerization.

The resin composition used in the present invention may contain polyester other than PBT for the purpose of adjusting the film formability during biaxial stretching and the mechanical characteristics of the obtained film.

Examples of the polyester other than PBT include at least one polyester selected from the group consisting of PET, polyethylene naphthalate, polybutylene naphthalate, and polypropylene terephthalate, PBT in which at least one dicarboxylic acid selected from the group consisting of isophthalic acid, orthophthalic acid, naphthalenedicarboxylic acid, biphenyldicarboxylic acid, cyclohexanedicarboxylic acid, adipic acid, azelaic acid, and sebacic acid is copolymerized, and PBT in which at least one diol component selected from the group consisting of ethylene glycol, 1,3-propylene glycol, 1,2-propylene glycol, neopentyl glycol, 1,5-pentanediol, 1,6-hexanediol, diethylene glycol, cyclohexanediol, polyethylene glycol, polytetramethylene glycol, and polycarbonate diol is copolymerized.

The upper limit of the added amount of these polyester resins other than PBT is preferably 30 mass% or less, more preferably 25 mass% or less. When the added amount of polyester other than PBT is more than 30 mass%, the mechanical characteristics of polybutylene terephthalate are impaired and troubles may arise that the transparency and gas barrier properties decrease as well as the impact strength, pinhole resistance, or bag breakage resistance is insufficient.

The lower limit of the intrinsic viscosity of polybutylene terephthalate (PBT) used in the present invention is preferably 0.9 dl/g, more preferably 0.95 dl/g, still more preferably 1.0 dl/g.

In the case where the intrinsic viscosity of polybutylene terephthalate (PBT) that is a raw material is less than 0.9 dl/g, the intrinsic viscosity of the film obtained by film formation decreases and the piercing strength, impact strength, pinhole resistance, bag breakage resistance or the like may decrease.

The upper limit of the intrinsic viscosity of polybutylene terephthalate is preferably 1.4 dl/g. When the intrinsic viscosity of polybutylene terephthalate exceeds the above value, the stress during stretching becomes too high and the film formability may be deteriorated. In the case of using polybutylene terephthalate having a high intrinsic viscosity, it is required to increase the extrusion temperature since the melt viscosity of the resin is high. However, when polybutylene terephthalate is extruded at a higher temperature, decomposition products are likely to be generated.

The resin composition may contain conventionally known additives, for example, a lubricant, a stabilizer, a coloring agent, an antistatic agent, and an ultraviolet absorber, if necessary.

As the kind of lubricant, organic lubricants as well as inorganic lubricants such as silica, calcium carbonate, and alumina are preferable, and silica and calcium carbonate are more preferable. Among the lubricants, silica is particularly preferable from the viewpoint of diminishing haze. The transparency and slippage are exerted by these lubricants.

The lower limit of the concentration of lubricant is preferably 100 ppm, more preferably 500 ppm, still more preferably 800 ppm. When the concentration of lubricant is less than the above value, the slippage of the base material film layer may decrease. The upper limit of the concentration of lubricant is preferably 20000 ppm, more preferably 10000 ppm, still more preferably 1800 ppm. When the concentration of lubricant exceeds the above value, the transparency may decrease.

In the base material layer in the present invention, the lower limit of the base material layer thickness is preferably 3 μm, more preferably 5 μm, still more preferably 8 μm. When the base material layer thickness is 3 μm or more, the strength as a base material film layer becomes sufficient.

The upper limit of the base material layer thickness is preferably 100 μm, more preferably 75 μm, still more preferably 50 μm. When the base material layer thickness is 100 μm or less, the processing for the object of the present invention becomes easier.

The upper limit of the heat shrinkage of the biaxially stretched polyester film constituting the base material layer in the present invention is preferably 4.0%, more preferably 3.0%, still more preferably 2% after the film is heated at 150°C for 15 minutes in the vertical stretching (longitudinal) direction (MD) and the horizontal stretching (transverse) direction (TD). When the heat shrinkage exceeds the upper limit, the inorganic thin film layer cracks by the dimensional changes of the base material film layer which occurs in the step of forming the inorganic thin film layer and protective layer and in the high temperature treatment such as retorting sterilization treatment, and not only the gas barrier properties may decrease but also pitch deviation may occur by the dimensional changes during processing such as printing.

The lower limit of the heat shrinkage of the biaxially stretched polyester film constituting the base material layer in the present invention is preferably 0% after the film is heated at 150°C for 15 minutes in the vertical stretching direction (MD) and the horizontal stretching direction (TD). Even when the heat shrinkage is below the lower limit, the effect of improvement is not obtained any more (is saturated) and the film may become mechanically brittle.

The lower limit of the impact strength of the biaxially stretched polyester film constituting the base material layer in the present invention is preferably 0.05 J/μm. When the impact strength is 0.05 J/μm or more, the strength becomes sufficient when the film is used as a bag.

The upper limit of the impact strength of the biaxially stretched polyester film constituting the base material layer in the present invention is preferably 0.2 J/μm. Even when the impact strength exceeds the upper limit, the effect of improvement is not obtained any more (is saturated).

The lower limit of the degree of plane orientation (ΔP) of the PBT film of the polyester film of the present invention is preferably 0.144, more preferably 0.148, still more preferably 0.15. When the degree of plane orientation is less than the above value, the orientation is weak, thus sufficient strength is not obtained and not only the piercing strength may decrease but also the gas barrier properties may decrease in the case where an inorganic thin film layer is provided on the base material film layer to form a laminated film since the polyester film is easily stretched depending on the tension and temperature applied during the inorganic thin film layer formation and the inorganic thin film layer cracks.

The upper limit of the degree of plane orientation (ΔP) of the polyester film in the present invention is preferably 0.160, more preferably 0.158. When the degree of plane orientation exceeds the above value, the orientation becomes too strong and breakage easily occur during film formation. As the orientation is increased, heat setting at a higher temperature is required to decrease the heat shrinkage and crystallization may rather decrease the strength of the film.

The upper limit of the haze per thickness of the biaxially stretched polyester film constituting the base material layer in the present invention is preferably 0.66%/$\mu$m, more preferably 0.60%/$\mu$m, still more preferably 0.53%/$\mu$m. When printing is performed on a base material layer having a haze per thickness of 0.66%/$\mu$m or less, the quality of printed characters and images is improved.

The upper limit of the intrinsic viscosity (I.V.) of the biaxially stretched polyester film constituting the base material layer in the present invention is preferably 1.20 dl/g, more preferably 1.15 dl/g, still more preferably 1.10 dl/g. When the intrinsic viscosity exceeds the upper limit, the strength of the film is improved but the pressure load applied to the filter during extrusion increases and it is difficult to produce the film. The lower limit of the intrinsic viscosity (I.V.) is preferably 0.60 dl/g, more preferably 0.65 dl/g, still more preferably 0.70 dl/g. When the intrinsic viscosity is below the lower limit, the strength of the film may decrease.

The biaxially stretched polyester film constituting the base material layer in the present invention may be subjected to a corona discharge treatment, a glow discharge treatment, a flame treatment, a surface roughening treatment and also subjected to known anchor coating treatment, printing, decoration, and the like as long as the object of the present invention is not impaired.

Next, a production method for obtaining the polyester film of the present invention will be specifically described. The production method is not limited thereto.

The production method for obtaining the polyester film of the present invention includes a step of meltextruding a polyester raw material resin into a sheet and cooling the sheet on a casting drum to mold an un-stretched sheet, vertical stretching step of stretching the un-stretched sheet thus molded in the longitudinal direction, a preheating step of preheating the stretched sheet to a temperature at which horizontal stretching is possible after the vertical stretching, a horizontal stretching step of stretching the stretched sheet in a transverse direction orthogonal to the longitudinal direction, a heat setting step of heating and crystallizing the film after subjected to the vertical stretching and the horizontal stretching, a thermal relaxation step of removing residual strain of the heat-set film, and a cooling step of cooling the film after thermal relaxation.

[Un-stretched Sheet Molding Step]

First, the film raw materials are dried or hot air dried. Next, the raw materials are weighed, mixed, supplied to an extruder, heated and melted, and melt-casted into a sheet.

The melted resin sheet is brought into close contact with a cooling roll (casting roll) to be cooled and solidified by an electrostatic application method to obtain an un-stretched sheet. The electrostatic application method is a method in which the resin sheet is charged by applying a voltage to an electrode installed in the vicinity of the melted resin sheet in contact with the rotating metal roll and in the vicinity of the surface opposite to the surface of the resin sheet in contact with the rotating metal roll and the resin sheet is brought into close contact with the rotating cooling roll.

The lower limit of the heating and melting temperature of the resin is preferably 200°C, more preferably 250°C, still more preferably 260°C. When the heating and melting temperature of the resin is less than the above value, the discharge may become unstable. The upper limit of the melting temperature of the resin is preferably 280°C, more preferably 270°C. When the melting temperature of the resin is more than the value, decomposition of the resin proceeds and the film becomes brittle.

Next, it is preferable to decrease the difference in crystallinity degree in the transverse direction when the melted polyester resin is extruded and cast onto the cooling roll. Examples of a specific method for this include a method in which raw materials having the same composition are multi-layered and cast when the melted polyester resin is extruded and cast and a method in which the cooling roll temperature is lowered.

A PBT resin has a high crystallization rate, and thus the crystallization thereof proceeds even during casting.

At this time, in the case of performing casting in monolayer without performing multi-layering, there is no obstacle that can inhibit growth of crystals, and thus these crystals are grown into large-sized spherulites. As a result, the yield stress of the obtained un-stretched sheet increases, and not only the un-stretched sheet is easily broken during biaxial stretching but also the obtained biaxially stretched film exhibits insufficient impact strength, pinhole resistance, or bag breakage resistance. On the other hand, by laminating the same resin in multiple layers, the stretching stress of the un-stretched sheet can be decreased and the subsequent biaxial stretching can be stably performed.

The method for multi-layering and casting the raw materials having the same composition when the melted polyester resin is extruded and cast specifically includes at least a step (1) of melting a resin composition containing PBT resin at 70 wt% or more to form a molten fluid; a step (2) of forming a laminated fluid having a number of lamination of 60 or more from the molten fluid thus formed; a step (3) of discharging the laminated fluid thus formed from a die and bringing the discharged fluid into contact with a cooling roll to be solidified to form a laminated un-stretched sheet; and a step (4) of biaxially stretching the laminated un-stretched sheet.

There is no problem even if other steps are inserted between the step (1) and the step (2) and between the step (2) and the step (3). For example, a filtration step, a temperature change step, and the like may be inserted between the step (1) and the step (2). Further, the temperature change step, a charge addition step, and the like may be inserted between the step (2) and the step (3). However, there should not be a step of breaking the laminated structure formed in the step (2) between the step (2) and the step (3).

In the step (1), the method of melting the polyester resin composition to form a molten fluid is not particularly limited, and a preferable method includes a method of melting the polyester resin composition under heat using a single screw extruder or a twin-screw extruder.

The method of forming the laminated fluid in the step (2) is not particularly limited. From the viewpoints of facility simplicity and maintainability, a static mixer and/or a multi-layer feed block is more preferable. Further, a static mixer and/or a multi-layer feed block having a rectangular melt line from the extruder to a die is more preferable, from the viewpoint of uniformity of the sheet in the transverse direction. It is still more preferable to use a static mixer or multi-layer feed block having a rectangular melt line. A resin composition composed of a plurality of layers formed by combining a plurality of resin compositions may be allowed to pass through any one of or two or more of a static mixer, a multi-layer feed block, or a multi-layer manifold.

The theoretical number of lamination in the step (2) is preferably 60 or more. The lower limit of the theoretical number of lamination is more preferably 500. When the theoretical number of lamination is too small, or the distance between layer interfaces becomes long, the crystal size becomes too large, and thus the effect of the present invention is unlikely to be obtained. Further, the crystallinity degree in the vicinity of both ends of the sheet increases, the film formation becomes unstable, and further the transparency after molding may decrease. The upper limit of the theoretical number of lamination in the step (2) is not particularly limited but is preferably 100,000, more preferably 10,000, still more preferably 7000. Even if the theoretical number of lamination is extremely increased, the effect may be saturated.

In the case where the lamination in the step (2) is performed by a static mixer, the theoretical number of lamination can be adjusted by selecting the number of elements of the static mixer. The static mixer is generally known as a static-type mixing device (line mixer) having no drive unit, and the fluid entering the mixer is sequentially stirred and mixed by the elements. However, when a high-viscosity fluid is passed through the static mixer, the high-viscosity fluid is divided and laminated to form a laminated fluid. Each time the high-viscosity fluid passes through one element of the static mixer, the high-viscosity fluid is divided into two and the two fluids are joined together and laminated. For this reason, a laminated fluid having a theoretical number of lamination $N = 2^n$ is formed when a high-viscosity fluid is allowed to pass through a static mixer having n elements.

A typical static mixer element has a structure in which a rectangular plate is twisted by 180 degrees, and a right element and a left element are present depending on the twisting direction. The dimensions of each element are basically as follows: the length is 1.5 times the diameter. The static mixer that can be used in the present invention is not limited to those described above.

In the case where the lamination in the step (2) is performed by a multi-layer feed block, the theoretical number of lamination can be adjusted by selecting the number of times of division and lamination of the multi-layer feed block. It is possible to install a plurality of multi-layer feed blocks in series. Further, it is also possible to use, as a laminated fluid, a high-viscosity fluid itself supplied to the multi-layer feed block. For example, in the case where the number of lamination of the high-viscosity fluid supplied to the multi-layer feed block is p, the number of division and lamination of the multi-layer feed block is q, and the number of multi-layer feed blocks installed is r, the number of lamination N of the laminated fluid is $N = p \times qr$.

In the step (3), the laminated fluid is discharged from a die and brought into contact with a cooling roll to be solidified.

The lower limit of the cooling roll temperature is preferably -10°C. When the cooling roll temperature is less than the above value, the crystallization suppressing effect may be saturated. The upper limit of the cooling roll temperature is preferably 40°C. When the cooling roll temperature exceeds the above value, the crystallinity degree becomes too high and it may be difficult to perform stretching. The upper limit of the cooling roll temperature is preferably 25°C. When the cooling roll temperature is in the above range, it is preferable to lower the humidity of the environment in the vicinity of the cooling roll in order to prevent dew formation. It is preferable to decrease the temperature difference in the width direction of the cooling roll surface. At this time, the thickness of the un-stretched sheet is preferably in a range of 15 to 2500 $\mu$m.

The un-stretched sheet having a multi-layer structure described above has at least 60 layers or more, preferably 250 layers or more, still more preferably 1000 layers or more. If the number of layers is small, the effect of improving stretchability is lost.

[Vertical Stretching and Horizontal Stretching Steps]

Next, a stretching method will be described. The stretching method can be simultaneous biaxial stretching or sequential biaxial stretching, but it is required to increase the degree of plane orientation in order to increase the piercing strength and sequential biaxial stretching is most preferable from the viewpoint of a high film forming speed and high productivity.

The lower limit of the stretching temperature in the vertical stretching direction is preferably 55°C, more preferably 60°C. Breakage is unlikely to occur when the stretching temperature is 55°C or more. Moreover, since the degree of vertical orientation of the film does not become too strong, shrinkage stress during heat setting treatment is suppressed and a film with less distortion of molecular orientation in the transverse direction is obtained. The upper limit of the stretching temperature in the vertical stretching direction is preferably 100°C, more preferably 95°C. When the stretching temperature is 100°C or less, the orientation of the film does not become too weak and the mechanical characteristics of the film do not decrease.

The lower limit of the stretching ratio in the vertical stretching direction is preferably 2.8 times, particularly preferably 3.0 times. When the stretching ratio is 2.8 times or more, the degree of plane orientation increases and the piercing strength of the film is improved.

The upper limit of the stretching ratio in the vertical stretching direction is preferably 4.3 times, more preferably 4.0 times, particularly preferably 3.8 times. When the stretching ratio is 4.3 times or less, the degree of orientation of the film in the transverse direction does not become too strong, the shrinkage stress during the heat setting treatment does not become too large, the distortion of molecular orientation of the film in the transverse direction is diminished, and as a result, the straight tear properties in the machine direction are improved. The effect of improving the mechanical strength and thickness unevenness is saturated in this range.

The lower limit of the stretching temperature in the horizontal stretching direction is preferably 60°C. When the stretching temperature is 60°C or more, breakage may be unlikely to occur. The upper limit of the stretching temperature in the horizontal stretching direction is preferably 100°C. When the stretching temperature is 100°C or less, the degree of orientation in the transverse direction increases and the mechanical characteristics are thus improved.

The lower limit of the stretching ratio in the horizontal stretching direction is preferably 3.5 times, more preferably 3.6 times, particularly preferably 3.7 times. When the stretching ratio is 3.5 times or more, the degree of orientation in the transverse direction does not become too weak and the mechanical characteristics and thickness unevenness are improved. The upper limit of the stretching ratio in the horizontal stretching direction is preferably 5 times, more preferably 4.5 times, particularly preferably 4.0 times. When the stretching ratio is 5.0 times or less, the effect of improving the mechanical strength and thickness unevenness is maximized (saturated) even in this range.

[Heat Setting Step]

The lower limit of the heat setting temperature in the heat setting step is preferably 195°C, more preferably 200°C. When the heat setting temperature is 195°C or more, the heat shrinkage of the film decreases, the inorganic thin film layer is not easily damaged even after the boiling treatment, and thus the gas barrier properties are improved. The upper limit of the heat setting temperature is preferably 220°C. The base material film layer does not melt and is unlikely to become brittle when the heat setting temperature is 220°C or less.

[Thermal Relaxation Section Step]

The lower limit of the relaxation rate in the thermal relaxation section step is preferably 0.5%. When the relaxation rate is 0.5% or more, breakage may be unlikely to occur during heat setting. The upper limit of the relaxation rate is preferably 10%. When the relaxation rate is 10% or less, the shrinkage in the longitudinal direction during heat setting decreases, and as a result, the distortion of molecular orientation at the film edge is diminished and the straight tear properties are improved. In addition, the film is unlikely to sag and thickness unevenness is unlikely to occur.

[Cooling Step]

In the cooling step after relaxation has been performed in the thermal relaxation section step, the temperature of the surface of the edge of the polyester film is preferably 80°C or less.

When the temperature of the film edge after passing through the cooling step is more than 80°C, the edge is stretched by the tension applied when the film is wound, and as a result, the heat shrinkage in the machine direction of the edge increases. Hence, the heat shrinkage distribution in the transverse direction of the roll becomes non-uniform, streaky wrinkles are generated when such a roll is heated and conveyed for vapor deposition processing and the like, and the physical properties of the finally obtained gas barrier film may become non-uniform in the transverse direction.

In the cooling step, as a method for lowering the surface temperature of the film edge to 80°C or less, a method in which the edge is selectively cooled by providing a shielding plate on the center side in the transverse direction of the cooling zone and a method in which cold air is locally blown on the edge of the film as well as a method in which the temperature and air volume in the cooling step are adjusted can be used.

[Covering Layer]

In the laminated film of the present invention, a covering layer can be provided between the base material layer and the inorganic thin film layer for the purpose of securing barrier properties and laminate strength after boiling and retorting treatment.

Examples of the covering layer include covering layers obtained by adding curing agents such as epoxy-based curing agents, isocyanate-based curing agents, and melamine-based curing agents to resins such as urethane-based resins, polyester-based resins, acrylic-based resins, titanium-based resins, isocyanate-based resins, imine-based resins, and polybutadiene-based resins. Examples of the solvating medium (solvent) include aromatic solvents such as benzene and toluene; alcohol-based solvents such as methanol and ethanol; ketone-based solvents such as acetone and methyl ethyl ketone; ester-based solvents such as ethyl acetate and butyl acetate; and polyhydric alcohol derivatives such as ethylene glycol monomethyl ether. These resin compositions used for the covering layer preferably contain a silane coupling agent having at least one or more organic functional groups. Examples of the organic functional groups include an alkoxy group, an amino group, an epoxy group, and an isocyanate group. By the addition of the silane coupling agent, the laminate strength after retorting is further improved.

Among the resin compositions used for the covering layer, it is preferable to use a resin having an oxazoline group. The oxazoline group has high affinity with the inorganic thin film, and can react with a metal hydroxide and an oxygen deficiency portion of an inorganic oxide that is generated during formation of the inorganic thin film layer, and thus firm adhesion to an inorganic thin film layer is exhibited. The unreacted oxazoline group present in the covering layer can react with the carboxylic acid terminal generated by hydrolysis of the base material film and the covering layer to form a crosslink.

Any resin of a polyester resin, a urethane resin, or an acrylic resin may be mixed in the covering layer for the purpose of improving the close contact with the base material layer. In particular, a urethane resin is preferable from the viewpoint of close contact and an acrylic resin is preferable from the viewpoint of water resistance.

The method for forming the covering layer is not particularly limited, and, for example, conventionally known methods such as coating methods can be adopted. Examples of suitable methods among the coating methods include an off-line coating method and an in-line coating method. For example, in the case of an in-line coating method that is executed in a step of producing a biaxially stretched polyester film base material constituting a base material layer, it is preferable to send the biaxially stretched polyester film to a stretching step in a perpendicular direction immediately after coating and to perform drying in a pre-heating zone or a stretching zone in the stretching step although the conditions for drying and heat treatment during coating depend on the coating thickness or conditions of the apparatus. Normally, the temperature is preferably set to about 50°C to 250°C in such a case. A method in which a sequential biaxial stretching method is adopted, the film after MD stretching is coated, and then TD stretching is performed is more preferable.

In the present invention, the amount of the covering layer attached is preferably 0.010 to 0.200 $g/m^2$. This makes it possible to uniformly control the covering layer, and as a result, the inorganic thin film layer can be densely deposited. Moreover, the cohesive force inside the covering layer is improved, the close contact properties between the respective layers of the base material layercovering layer-inorganic thin film layer also increase, and thus the water resistance and adhesive properties of the covering layer can be enhanced. The amount of the covering layer attached is preferably 0.015 $g/m^2$ or more, more preferably 0.020 $g/m^2$ or more, still more preferably 0.025 $g/m^2$ or more and preferably 0.190 $g/m^2$ or less, more preferably 0.180 $g/m^2$ or less, still more preferably 0.170 $g/m^2$ or less. When the amount of the covering layer attached is more than 0.200 $g/m^2$, the cohesive force inside the covering layer becomes insufficient and favorable close contact properties may not be exerted. In addition, since the uniformity of the covering layer is also diminished, defects may be generated in the inorganic thin film layer and the gas barrier properties may decrease. Moreover, the production cost increases and this is economically disadvantageous. On the other hand, when the film thickness of the covering layer is less than 0.010 $g/m^2$, the base material cannot be sufficiently covered and sufficient gas barrier properties and interlayer close contact properties may not be obtained.

If necessary, the resin composition for covering layer may contain various known inorganic and organic additives such as an antistatic agent, a slipping agent, and an anti-blocking agent as long as the present invention is not impaired.

[Inorganic Thin Film Layer]

In the base material laminated film of the present invention, an inorganic thin film layer is laminated. The inorganic thin film layer is a thin film formed of an inorganic oxide. The material for forming the inorganic thin film layer is not particularly limited as long as the material can be formed into a thin film. From the viewpoint of gas barrier properties, inorganic oxides such as silicon oxide (silica), aluminum oxide (alumina), a mixture (composite oxide) of silicon oxide and aluminum oxide are preferable. Particularly, a composite oxide of silicon oxide and aluminum oxide is preferable from the viewpoint of satisfying both flexibility and denseness of the thin film layer. In this composite oxide, regarding the mixing ratio of the silicon oxide and the aluminum oxide, the metal mass ratio of Al is preferably in a range of 20 mass% to 70 mass%. The barrier properties may decrease when the Al concentration is less than 20 mass%. On the other hand, when the Al concentration is more than 70 mass%, the inorganic thin film layer tends to be hard, the film may be broken during secondary processing such as printing or lamination, and the barrier properties may decrease. The silicon oxide used herein is various silicon oxides such as SiO and $SiO_2$ or a mixture thereof, and the aluminum oxide used herein is various aluminum oxides such as AlO and $Al_2O_3$ or a mixture thereof.

The thickness of the inorganic thin film layer is usually in a range of 1 to 100 nm, and preferably in a range of 5 to 50 nm. When the thickness of the inorganic thin film layer is less than 1 nm, it may be difficult to obtain satisfactory gas barrier properties. On the other hand, even if the thickness is excessively thicker than 100 nm, the effect of improving the gas barrier properties along with excessive thickness is not obtained, and it is rather disadvantageous in terms of flex resistance and production cost.

The method for forming the inorganic thin film layer is not particularly limited, and known vapor deposition methods, for example, physical vapor deposition methods (PVD methods) such as a vacuum vapor deposition method, a sputtering method, and an ion plating method, or chemical vapor deposition methods (CVD methods) may be adopted as appropriate. Hereinafter, a typical method for forming the inorganic thin film layer will be described by taking a silicon oxide-aluminum oxide based thin film as an example. For example, in the case of adopting the vacuum vapor deposition method, a mixture of $SiO_2$ and $Al_2O_3$, a mixture of $SiO_2$ and Al or the like is preferably used as a vapor deposition material. Usually, particles are used as these vapor deposition materials. In this case, the size of each particle is desirably a size that does not change the pressure during vapor-deposition, and the preferable particle size is in a range of 1 mm to 5 mm. For heating, systems such as resistive heating, high frequency induction heating, electron beam heating, and laser heating can be adopted. It is also possible to adopt reactive vapor deposition by introducing oxygen, nitrogen, hydrogen, argon, carbon dioxide gas, water vapor or the like as a reaction gas or using a means such as ozone addition or ion assist. The film forming conditions such as applying a bias to a body to be vapor-deposited (laminated film to be vapor-deposited) or heating or cooling a body to be vapor-deposited can be arbitrarily changed. Similarly, the vapor deposition materials, the reaction gases, the application of a bias to the body to be vapor-deposited, and the heating/cooling and the like can be changed even when a sputtering method or a CVD method is adopted.

In the present invention, a protective layer may be provided on the inorganic thin film layer, if necessary. The inorganic thin film layer is not a completely dense film and has dotted microscopic deficient moieties. By applying a resin composition for protective layer onto the inorganic thin film layer to form a protective layer, a resin in the resin composition for protective layer invades the deficient moieties of the inorganic thin film layer, and as a result, an effect of stabilizing the gas barrier properties is obtained. Since degradation of the barrier properties when a printing layer is laminated can be suppressed, printing is possible. Additionally, by using a material exhibiting gas barrier properties in the protective layer itself, the gas barrier performance of the laminated film can also be largely improved.

Examples of the protective layer formed on the surface of the laminated film of the present invention include protective layers obtained by adding curing agents such as epoxy-based curing agents, isocyanate-based curing agents, and melamine-based curing agents to resins such as urethane-based resins, polyester-based resins, acrylic-based resins, titanium-based resins, isocyanate-based resins, imine-based resins, and polybutadiene-based resins. Examples of the solvating medium (solvent) include aromatic solvents such as benzene and toluene; alcohol-based solvents such as methanol and ethanol; ketone-based solvents such as acetone and methyl ethyl ketone; ester-based solvents such as ethyl acetate and butyl acetate; and polyhydric alcohol derivatives such as ethylene glycol monomethyl ether.

[Lamination with Heat-sealable Resin Layer]

The laminated film of the present invention is preferably used by being bound with a heat-sealable resin layer called a sealant. A heat-sealable resin layer is usually provided on the inorganic thin film layer side (on the protective layer surface when the protective layer is formed on the inorganic thin film layer) but may be provided on the outer side (the surface on the opposite side to the covering layer formed surface) of the base material film. The heat-sealable resin layer is usually formed by an extrusion lamination method or a dry lamination method using a sealant film. As a thermoplastic polymer that forms the heat-sealable resin layer, any one may be used as long as the adhesive properties of the sealant can be sufficiently exerted. Polyethylene resins such as HDPE, LDPE or LLDPE, a polypropylene resin, an ethylene-vinyl acetate copolymer, an ethylene-α-olefin random copolymer, and an ionomer resin can be used. The thickness of the heat-sealable resin layer is preferably 20 μm or more, more preferably 25 μm or more, still more preferably 30 μm or more and preferably 80 μm or less, more preferably 75 μm or less, still more preferably 70 μm or less. When the thickness is 20 μm or less, the productivity deteriorates. On the other hand, when the thickness is 80 μm or more, the cost increases and the transparency also deteriorates.

[Other Layers]

In the laminated film of the present invention, at least one or more layers of a printing layer and another plastic base material and/or a paper base material may be laminated between the laminated film and the heat-sealable resin layer.

[Adhesive Layer]

For the adhesive layer used in the present invention, a general-purpose adhesive for lamination can be used. For example, it is possible to used solvent (free) type, aqueous type, and hot melt type adhesives containing poly(ester) urethane-based materials, polyester-based materials, polyamide-based materials, epoxy-based materials, poly (meth)acrylic-based materials, polyethyleneimine-based materials, ethylene-(meth)acrylic acid-based materials, polyvinyl acetate-based materials, (modified) polyolefinbased materials, polybutadiene-based materials, wax-based materials, casein-based materials and the like as a main component. Among these, urethane-based or polyester-based materials are preferable in consideration of moisture and heat resistance that can withstand retorting treatment and flexibility that can follow the dimensional changes of each base material. As a method for laminating the adhesive layer, for example, the adhesive layer can be coated by a direct gravure coating method, a reverse gravure coating method, a kiss coating method, a die coating method, a roll coating method, a dip coating method, a knife coating method, a spray coating method, a fountain coating method, and other methods. The coated amount after drying is preferably 1 to 8 $g/m^2$ in order to exert sufficient adhesive properties after retorting. The coated amount is more preferably 2 to 7 $g/m^2$, still more preferably 3 to 6 $g/m^2$. When the coated amount is less than 1 $g/m^2$, it is difficult to paste the entire surface and the adhesive strength decreases. When the coated amount is more than 8 $g/m^2$, it takes time to completely cure the film, unreacted substances are likely to remain, and the adhesive strength decreases.

As a printing ink for forming the printing layer, aqueous and solvent-based resin-containing printing inks can be preferably used. Examples of the resin to be used in the printing ink include acrylic-based resins, urethane-based resins, polyester-based resins, vinyl chloride-based resins, vinyl acetate copolymer resins, and mixtures thereof. The printing ink may contain known additives such as an antistatic agent, a light blocking agent, an ultraviolet absorber, a plasticizer, a lubricant, a filler, a coloring agent, a stabilizer, a lubricating agent, a defoaming agent, a crosslinking agent, an anti-blocking agent, and an oxidation inhibitor. The printing method for providing the printing layer is not particularly limited, and known printing methods such as an offset printing method, a gravure printing method, and a screen printing method can be used. In order to dry the solvent after printing, known drying methods such as hot air drying, hot roll drying, and infrared drying can be used.

In the laminated film of the present invention, the value of the barrier value deterioration rate under a high-temperature and high-humidity condition determined by a formula (b) B/A × 100 [%] is required to be 300% or less when the value of oxygen transmission rate under a 23°C×65%RH condition is defined as (A) and the value of oxygen transmission rate under a 40°C×90%RH condition is defined as (B). The deterioration rate can be set to preferably 250% or less, more preferably 200% or less. When the deterioration rate is more than 300%, it is difficult to meet applications that are required to exhibit gas barrier properties in a high-temperature and high-humidity environment.

In the laminated body of the present invention, the oxygen transmission rates of the laminated body before and after a boiling treatment are both preferably 30 $ml/m^2$·d·MPa or less, more preferably 25 $ml/m^2$·d·MPa or less, still more preferably 20 $ml/m^2$·d·MPa or less. When the oxygen transmission rate is more than 30 $ml/m^2$·d·MPa, the contents may be degraded by oxidation.

In the laminated body of the present invention, the water vapor transmission rates of the laminated body before and after a boiling treatment are both preferably 2.5 $g/m^2$·d or less, more preferably 2.0 $g/m^2$·d or less, still more preferably 1.5 $g/m^2$·d or less. When the water vapor transmission rate is more than 2.5 $g/m^2$·d, the quality and aroma retaining properties may decrease by the loss of water in the contents.

In the laminated body of the present invention, the watering laminate strengths of the laminated body under a 23°C × 65%RH condition before and after a boiling treatment are both preferably 2.0 N/15 mm or more, more preferably 2.5 N/15 mm or more, still more preferably 3.0 N/15 mm or more. When the laminate strength is less than 2.0 N/15 mm, peeling off may occur by the bending load or liquid contents and the barrier properties may be degraded or the contents may leak. Furthermore, the hand-cutting properties may deteriorate.

The piercing strength of the laminated film of the present invention after having undergone a 95°C-boiling treatment for 30 minutes as measured in accordance with JIS Z 1707 is preferably 0.6 N/μm or more, more preferably

0.7 N/$\mu$m or more, still more preferably 0.8 N/$\mu$m or more. When the piercing strength is less than 0.6 N/$\mu$m, the bag may be punctured and the contents may leak if an external load is applied when the laminated film is used as a bag.

EXAMPLES

Next, the present invention will be described in detail with reference to Examples and Comparative Examples, but the present invention is naturally not limited to the following Examples. Unless otherwise stated, "%" means "% by mass" and "parts" means "parts by mass".

The evaluation methods used in the present invention are as follows.

(1) Thickness of laminated film

The thickness of the laminated film was measured using a dial gauge in conformity with JIS K7130-1999 method A.

(2) Degree of plane orientation $\Delta$P of laminated film

In accordance with the JIS K 7142-1996 A method, the refractive index (Nx) in the longitudinal direction of the film and the refractive index (Ny) in the transverse direction were measured for a sample using sodium D-ray as a light source and Abbe refractometer, and the degree of plane orientation $\Delta$P was calculated by Formula (1).

$$\text{Degree of plane orientation } (\Delta P) = (Nx + Ny)/2 - Nz \quad (1)$$

(3) Heat shrinkage of laminated film

The heat shrinkage of the polyester film constituting the base material layer was measured by a dimensional change testing method described in JIS-C-2151-2006. 21 except that the test temperature was adjusted to 150°C and the heating time was adjusted to 15 minutes. The test piece was used in accordance with the description in 21.1 (a) .

(4) Intrinsic viscosity I.V. of raw material resin or laminated film

A sample was vacuum dried at 130°C for a whole day and night, then crushed or cut, and precisely weighed by 80 mg, and heated and dissolved in a mixed solution of phenol/tetrachloroethane = 60/40 (volume ratio) at 80°C for 30 minutes. The resultant solution was adjusted to have a volume of 20 ml with the same mixed solution and then subjected to the measurement at 30°C.

(5) Piercing strength of laminated film after boiling

The films obtained in Examples and Comparative Examples were boiled by being held in hot water at 95°C for 30 minutes. The films obtained after the boiling treatment were sampled by 5 cm squares. The piercing strength (after boiling) of the films was measured in conformity with JIS Z 1707 using Digital Force Gauge "ZTS-500N", Motorized Test Stand "MX2-500N", and Film Puncture Testing Fixture "TKS-250N" manufactured by IMADA Co., Ltd.. The unit was N/$\mu$m.

(6) Barrier value deterioration rate of laminated film under high-temperature and high-humidity condition

The oxygen transmission rate (A) of the laminated films obtained in Examples and Comparative Examples was measured in an atmosphere having a temperature of 23°C and a humidity of 65% RH in conformity with JIS-K7126 B method using an oxygen permeation analyzer ("OX-TRAN (registered trademark) 1/50" manufactured by AMETEK MOCON). The oxygen transmission rate was measured in the direction in which oxygen permeated from the surface side of the film on which the inorganic thin film layer was not laminated to the surface side of the inorganic thin film. Similarly, the oxygen transmission rate (B) was measured in an atmosphere having a temperature of 40°C and a humidity of 90% RH, and the barrier value deterioration rate (b) B/A $\times$ 100 [%] was calculated.

(7) Fabrication of laminated body for evaluation

A polyurethane-based adhesive (TM569 manufactured by Toyo-Morton, Ltd.) was applied to the protective layer surface of the laminated films obtained in Examples and Comparative Examples so that the thickness after drying at 80°C was 3 $\mu$m. A linear low-density polyethylene film (L4102 manufactured by TOYOBO CO., LTD.; thickness: 40 $\mu$m; referred to as LL) was then dry-laminated thereon on a metal roll heated to 60°C. Aging was performed at 40°C for 4 days, thereby obtaining a gas barrier laminated body for evaluation (hereinafter, also referred to as "laminated body").

(8) Method for evaluating oxygen transmission rate (OTR) of laminated body before and after boiling

The normal oxygen transmission rate of the laminated body fabricated in (5) above was measured in an atmosphere having a temperature of 23°C and a humidity of 65% RH in conformity with JIS-K7126 B method using an oxygen permeation analyzer ("OX-TRAN (registered trademark) 1/50" manufactured by AMETEK MOCON). The oxygen transmission rate was measured in the direction in which oxygen permeated from the base material film side of the laminated body to the heat-sealable resin layer side. On the other hand, the oxygen transmission rate (after boiling) of the laminated body after moist heat treatment obtained by holding the laminated body fabricated in (5) above in hot water at 95°C for 30 minutes for a moist heat treatment and drying the laminated body at 40°C for 1 day (24 hours) was measured in the same manner as above.

(9) Method for evaluating water vapor transmission rate (WVTR) of laminated body before and after boiling

The normal water vapor transmission rate of the laminated body fabricated in (5) above was measured in an atmosphere having a temperature of 40°C and a humidity of 90% RH in conformity with JIS-K7129 B method using a water vapor permeation analyzer ("PERMATRAN-W3/33MG" manufactured by AMETEK MOCON). The water vapor transmission rate was measured in the direction in which water vapor permeated from the heat-sealable resin layer side of the laminated body to the base material film side.
On the other hand, the water vapor transmission rate (after boiling) of the laminated body after moist heat treatment obtained by holding the laminated body fabricated in (5) above in hot water at 95°C for 30 minutes for a moist heat treatment and drying the laminated body at 40°C for 1 day (24 hours) was measured in the same manner as above.

(10) Method for evaluating laminate strength of laminated body before and after boiling

The laminated body fabricated in (5) above was cut into a test piece having a width of 15 mm and a length of 200 mm and subjected to the measurement of laminate strength (normal) using a Tensilon universal material testing machine ("Tensilon UMT-II-500 type" manufactured by Toyo Baldwin Co., Ltd.) under the conditions of a temperature of 23°C and a relative humidity of 65%. As the measurement of laminate strength, the strength was measured when water was applied between the laminated film layer and the heat-sealable resin layer of each of the laminated films obtained in Examples and Comparative Examples and the layers were peeled off from each other at a peeling angle of 90 degrees at a tensile speed of 200 mm/min.
On the other hand, the laminated body fabricated above was held in hot water at 95°C for 30 minutes for a boiling treatment. Thereafter, a test piece was immediately cut out from the obtained laminated body after the boiling treatment in the same manner as above and subjected to the measurement of laminate strength (after boiling treatment) in the same manner as above.
The details of the raw material resins and the coating liquids used in the present Examples and Comparative Examples are described below. The raw material resins and the coating liquids were used in Examples 1 to 6 and Comparative Examples 1 to 7 and presented in Table 1.

1) Base material film layer A

Polybutylene terephthalate (PBT): 1100-211XG (CHANG CHUN PLASTICS CO., LTD., intrinsic viscosity: 1.28 dl/g) was used as polybutylene terephthalate used in the film fabrication described later.
Polyethylene terephthalate (PET): Terephthalic acid//ethylene glycol = 100//100 (mol%) (manufactured by TOYOBO CO., LTD., intrinsic viscosity: 0.62 dl/g) was used as polyethylene terephthalate used in the film fabrication described later

2) Resin having oxazoline group (A): A commercially available water-soluble oxazoline groupcontaining acrylate ("EPOCROS (registered trademark) WS-300" manufactured by Nippon Shokubai Co., Ltd.; solid content: 10%) was prepared as the resin having an oxazoline group. The oxazoline group amount in this resin was 7.7 mmol/g.

3) Acrylic resin (B): A commercially available 25 mass% emulsion of acrylic ester copolymer ("MOVINYL (registered trademark) 7980" manufactured by Nichigo-Movinyl Co. Ltd.) was prepared as the acrylic resin. The acid value (theoretical value) of this acrylic resin was 4 mg KOH/g.

4) Urethane resin (C): A commercially available polyester urethane resin dispersion ("TAKELAC (registered trademark) W605" manufactured by Mitsui Chemicals, Inc.: solid content: 30%) was prepared as the urethane resin. The acid value of this urethane resin was 25 mg KOH/g and the glass transition temperature (Tg) thereof measured by DSC was 100°C. The proportion of aromatic or aromatic aliphatic diisocyanate to the total polyisocyanate components measured by $^1$H-NMR was 55 mol%.

5) Coating liquid 1 used for covering layer

The respective materials were mixed at the following blending ratio to prepare a coating liquid 1 (resin composition for covering layer).

Water 50.53 mass%
Isopropanol 22.00 mass%
Oxazoline group-containing resin (A) 20.00 mass%
Acrylic resin (B) 4.80 mass%
Urethane resin (C) 2.67 mass%

The method for fabricating the base material film layer A used in Examples 1 to 6 and Comparative Examples 1 to 5 will be described below.

<Example 1>

Silica particles having an average particle size of 2.4 $\mu$m as inert particles were blended in a mixture obtained by mixing 80 mass% of PBT resin and 20 mass% of PET resin so that the silica concentration was 900 ppm with respect to the mixed resin. The resultant mixture was melted at 290°C using a single axis extruder, and then a melt line was introduced into a static mixer having 12 elements. The polyester resin melt was thus divided and laminated to obtain a multi-layer melt formed from the same raw material. The melt was cast from a T-die at 265°C and brought into close contact with a cooling roll at 15°C by an electrostatic adhesion method to obtain an un-stretched sheet.

Subsequently, the un-stretched sheet was roll-stretched 2.9 times in the machine direction at 60°C, and the resin composition for adhesive layer (coating liquid 1) was applied to the stretched sheet by a fountain bar coating method after the vertical stretching. Thereafter, the sheet was guided to a tenter while being dried, then allowed to pass through the tenter and stretched 4.0 times in the transverse direction at 90°C, and subjected to a tension heat treatment at 200°C for 3 seconds and a 9% relaxation treatment for 1 second, and then the film was cooled at 50°C for 2 seconds. The surface temperature at the film edge at this time was 75°C.

Next, the holding portions at both edges were cut and removed by 9% to obtain a laminated film in which a covering layer of 0.030 g/m$^2$ was formed on a polyester film having a thickness of 15 $\mu$m. The physical properties of the obtained film are presented in Table 1.

<Examples 2 to 6 and Comparative Examples 1 to 5>

The same procedure as in Example 1 was performed except that the presence or absence of the covering layer, the ratio of PBT, the vertical stretching ratio, the heat setting temperature, the relaxation rate, and the tenter cooling step zone temperature in the film forming step of the base material film layer A were changed as presented in Table 1. The physical properties of the obtained biaxially stretched polyester films are presented in Table 1.

The method for fabricating the base material film layer B used in Comparative Example 6 will be described below.

<Comparative Example 6>

A polyethylene terephthalate resin having an intrinsic viscosity of 0.62 dl/g (30°C, phenol/tetrachloroethane = 60/40) was pre-crystallized, then dried, extruded at 280°C using an extruder equipped with a T-die, and rapidly cooled and solidified on a drum having a surface temperature of 40°C to obtain an amorphous sheet. Next, the obtained sheet was stretched between a heating roll and a cooling roll 4.0 times at 100°C in the machine direction. One surface of the obtained uniaxially stretched film was then coated with the coating liquid 1 by a fountain bar coating method. The film was guided to a tenter while being dried, preheated at 100°C, stretched 4.0 times at 120°C in the transverse direction, and subjected to a heat treatment at 225°C while being subjected to 6% relaxation in the transverse direction to obtain a laminated film in which a covering layer of 0.020 g/m$^2$ was formed on a biaxially stretched polyester film having a

thickness of 12 μm. The physical properties of the obtained film are presented in Table 1.

The method for fabricating the base material film layer C used in Comparative Example 7 will be described below.

<Comparative Example 7>

Polycaproamide is heated and melted at 260°C and extruded into a sheet from a T-die using a screw-type extruder. This un-stretched sheet was then stretched between a heating roll and a cooling roll 3.3 times at 80°C in the machine direction. One surface of the obtained uniaxially stretched film was then coated with the coating liquid 1 by a fountain bar coating method. The film was then guided to a tenter, stretched 4.0 times at 120°C in the transverse direction, and subjected to heat setting at 215°C to obtain a laminated film in which a covering layer of 0.020 g/m² was formed on a biaxially stretched polyamide film having a thickness of 15 μm. The physical properties of the obtained film are presented in Table 1.

The method for forming an inorganic thin film layer in each Example and Comparative Example will be described below.

<Formation of Inorganic Thin Film Layer>

A composite oxide layer of silicon dioxide and aluminum oxide was formed as an inorganic thin film layer on the base material film layer A, B, or C by an electron beam vapor deposition method. Particulate $SiO_2$ (purity: 99.9 %) and $Al_2O_3$ (purity: 99.9%) having a size of about 3 mm to 5 mm were used as a vapor deposition source. The film thickness of the inorganic thin film layer ($SiO_2/Al_2O_3$ composite oxide layer) in the film (inorganic thin film layer/covering layer-containing film) obtained as described above was 13 nm. The composition of this composite oxide layer was $SiO_2/Al_2O_3$ (mass ratio) = 55/45.

The base material laminated films and laminated bodies thereof obtained are 13 kinds in total, and the evaluation results of these are presented in Table 1.

[Table 1]

| | Item | | Unit | Example 1 | 2 | 3 | 4 | 5 | 6 | Comparative Example 1 | 2 | 3 | 4 | 5 | 6 | 7 |
|---|---|---|---|---|---|---|---|---|---|---|---|---|---|---|---|---|
| Raw material | PBT resin | Ratio | % by weight | 80 | 90 | 100 | 75 | 80 | 80 | 80 | 65 | 60 | 70 | 100 | – | – |
| | Polyester resin other than PBT | Name | – | PET | PET | PET | PET | PET | PET | PET | PET | PET | PET | – | PET | Polyamide |
| | | Ratio | % by weight | 20 | 10 | 0 | 25 | 20 | 20 | 20 | 35 | 40 | 30 | – | 100 | 100 |
| Production condition of laminated film | MD stretching temperature | | °C | 65 | 65 | 65 | 65 | 65 | 65 | 65 | 80 | 60 | 60 | 65 | | |
| | MD stretching ratio | | MD | 2.9 | 2.9 | 2.9 | 2.9 | 3.5 | 4 | 2.9 | 3 | 3.8 | 3.8 | 2.8 | | |
| | TD stretching temperature | | °C | 90 | 90 | 90 | 90 | 90 | 90 | 90 | 90 | 90 | 90 | 90 | | |
| | TD stretching ratio | | MD | 4 | 4 | 4 | 4 | 4 | 4 | 4 | 4 | 4 | 4 | 4 | | |
| | Heat setting temperature | | °C | 200 | 200 | 200 | 200 | 200 | 200 | 200 | 210 | 210 | 210 | 215 | | |
| | TD relaxation rate | | % | 9 | 9 | 9 | 9 | 9 | 9 | 9 | 5 | 5 | 5 | 1 | | |
| | TD cooling z temperature | | °C | 50 | 50 | 50 | 50 | 35 | 35 | 50 | 80 | 80 | 80 | 80 | | |
| | Film edge temperature at TD outlet | | °C | 75 | 75 | 75 | 75 | 62 | 62 | 75 | 87 | 87 | 87 | 87 | | |
| | Covering layer | | – | Presence | Presence | Presence | Presence | Presence | Presence | – | Presence | Presence | Presence | Presence | Presence | Presence |
| | Inorganic thin film layer | | – | Presence | Presence | Presence | Presence | Presence | Presence | Presence | Presence | Presence | Presence | Presence | Presence | Presence |
| Physical properties of laminated film | Thickness (μm) | | μm | 15 | 15 | 15 | 15 | 15 | 15 | 15 | 15 | 15 | 15 | 15 | 12 | 15 |
| | Film I.V. | | dl/g | 0.931 | 1.05 | 1.16 | 0.87 | 0.931 | 0.931 | 0.931 | 0.86 | 0.86 | 0.89 | 1.1 | – | – |
| | Heat shrinkage | MD | % | 2.5 | 2.5 | 2.6 | 2.4 | 2.6 | 2.9 | 2.5 | 1.9 | 1.8 | 1.5 | 1.7 | 1.16 | 0.8 |
| | | TD | % | 0.4 | 0.37 | 0.37 | 0.37 | 0.37 | 0.37 | 0.4 | 0.9 | 0.50 | 0.50 | 2.10 | 0.07 | 0.70 |
| | Piercing strength (after boiling) | | N/μm | 0.68 | 0.78 | 0.86 | 0.65 | 0.71 | 0.748 | 0.68 | 0.56 | 0.41 | 0.43 | 0.57 | 0.47 | 0.76 |
| | Degree of plane orientation | | – | 0.1475 | 0.1495 | 0.1500 | 0.1467 | 0.152 | 0.158 | 0.1475 | 0.1483 | 0.142 | 0.142 | 0.143 | 0.162 | 0.061 |
| | Impact strength | | J/μm | 0.059 | 0.066 | 0.074 | 0.055 | 0.071 | 0.074 | 0.059 | 0.055 | 0.04 | 0.04 | 0.054 | 0.032 | 0.067 |
| | Barrier deterioration rate at high temperature and high humidity | OTR | % | 268 | 264 | 276 | 248 | 259 | 248 | 285 | 276 | 270 | 291 | 291 | 281 | 2570 |
| Physical properties of laminated product | Laminate strength | Normal | N/15mm | 2.4 | 2.5 | 2.5 | 2.6 | 2.3 | 2.6 | 2.5 | 2.5 | 2.5 | 2.5 | 2.5 | 2.3 | 2.2 |
| | | After boiling | N/15mm | 2 | 2.9 | 3 | 2.7 | 2.6 | 2.7 | 0.8 | 2.5 | 2.4 | 2.6 | 2.6 | 2.3 | 11.3 |
| | Barrier properties | Normal OTR | ml/m²·day·MPa | 7 | 8 | 8 | 8 | 8 | 8 | 12 | 9 | 8 | 18 | 18 | 8 | 20 |
| | | Normal WVTR | g/m²·day | 1.2 | 1.3 | 1.5 | 1.3 | 1.3 | 1.3 | 1.8 | 1.3 | 1.5 | 1.5 | 1.5 | 1.5 | 3.0 |
| | | After boiling OTR | ml/m²·day·MPa | 19 | 10 | 11 | 11 | 12 | 11 | 50 | 11 | 10 | 32 | 32 | 11 | 144 |
| | | After boiling WVTR | g/m²·day | 1.8 | 1.2 | 1.4 | 1.3 | 1.3 | 1.3 | 2.9 | 1.4 | 1.5 | 3.1 | 3.1 | 1.4 | 10 |

INDUSTRIAL APPLICABILITY

According to the present invention, the barrier performance is excellent even in a high-temperature and high-humidity environment. Hence, degradation of the contents can be suppressed even in harsh transportation and storage environments. The laminated film has excellent barrier properties and adhesive properties before and after a boiling treatment, and there is thus no problem that the contents are degraded or the contents leak. The laminated film exhibits excellent toughness as a base material, there is little risk that the bag is punctured or torn. The laminated film of the present invention exhibits excellent processability and can be easily produced, and it is thus possible to provide a gas barrier film which exhibits both excellent economical efficiency and excellent production stability and exhibits homogeneous characteristics.

**Claims**

1. A laminated film that comprises at least three layers of a base material layer/a covering layer/an inorganic thin film layer laminated in this order and satisfies the following requirements (a)-(d):

   (a) the base material layer comprises a resin composition that contains 70 mass% or more of polybutylene terephthalate resin;
   (b) the laminated film has a piercing strength of 0.6 N/$\mu$m or more as measured in accordance with JIS Z 1707 after having undergone a 95°C-boiling treatment for 30 minutes;
   (c) the base material layer has a surface orientation degree of 0.144-0.160; and
   (d) when the value of oxygen transmission rate obtained by measuring the laminated film under a 23°C×65%RH condition is defined as (A) and the value of oxygen transmission rate obtained by measuring same under a 40°C×90%RH condition is defined as (B), the barrier value deterioration rate, determined by the following formula, of the laminated film is 300% or less under high-temperature and high-humidity condition.

$$\text{Barrier value deterioration rate (\%) under high-temperature and high-humidity condition} = (B/A) \times 100$$

2. The laminated film according to claim 1, wherein the base material layer further satisfies the following requirement (e):
   (e) heat shrinkages of the base material layer at 150°C in a longitudinal direction and a transverse direction are both 4.0% or less.

3. The laminated film according to claim 1 or 2, wherein the inorganic thin film layer is a layer formed of a composite oxide of silicon oxide and aluminum oxide.

4. The laminated film according to any one of claims 1 to 3, wherein the covering layer comprises a resin composition containing a resin having an oxazoline group.

## INTERNATIONAL SEARCH REPORT

International application No.

PCT/JP2020/000131

### A. CLASSIFICATION OF SUBJECT MATTER
B32B 27/36(2006.01)i; B32B 9/00(2006.01)i
FI: B32B27/36; B32B9/00 A

According to International Patent Classification (IPC) or to both national classification and IPC

### B. FIELDS SEARCHED

Minimum documentation searched (classification system followed by classification symbols)
B32B1/00-43/00

Documentation searched other than minimum documentation to the extent that such documents are included in the fields searched
| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2017/126563 A1 (TOYOBO CO., LTD.) 27.07.2017 (2017-07-27) paragraphs [0064], [0065], [0083], [0086], [0087], examples 1-4 | 1-4 |
| X | JP 2018-20844 A (TOYOBO CO., LTD.) 08.02.2018 (2018-02-08) paragraphs [0057], [0058], [0065], [0066], [0079], example 1 | 1-4 |

☐ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 March 2020 (02.03.2020) | 17 March 2020 (17.03.2020) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**
Information on patent family members

International application No.

PCT/JP2020/000131

| Patent Documents referred in the Report | Publication Date | Patent Family | Publication Date |
|---|---|---|---|
| WO 2017/126563 A1 | 27 Jul. 2017 | EP 3406421 A1 paragraphs [0096]-[0098], [0128], [0131]-[0134], examples 1-4 CN 108472860 A KR 10-2018-0108670 A TW 201736453 A | |
| JP 2018-20844 A | 08 Feb. 2018 | WO 2019/021759 A1 TW 201910129 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4857482 B
- JP 2013154605 A
- JP 2012214248 A